(19) Europäisches Patentamt
European Patent Office
Office européen des brevets

(11) **EP 4 390 931 A1**

(12) **EUROPEAN PATENT APPLICATION**
published in accordance with Art. 153(4) EPC

(43) Date of publication:
26.06.2024 Bulletin 2024/26

(21) Application number: 21954344.4

(22) Date of filing: 16.11.2021

(51) International Patent Classification (IPC):
*G11C 11/4091* (2006.01)   *G11C 11/408* (2006.01)
*G11C 11/4094* (2006.01)   *H03M 1/12* (2006.01)

(52) Cooperative Patent Classification (CPC):
G11C 11/408; G11C 11/4091; G11C 11/4094;
H03M 1/12

(86) International application number:
PCT/KR2021/016738

(87) International publication number:
WO 2023/022298 (23.02.2023 Gazette 2023/08)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 17.08.2021 KR 20210108384

(71) Applicant: **Korea Advanced Institute of Science and Technology**
**Daejeon 34141 (KR)**

(72) Inventors:
• **CHO, Seong Hwan**
  **Daejeon 34141 (KR)**
• **LEE, Gi Woo**
  **Daejeon 34141 (KR)**

(74) Representative: **AWA Sweden AB**
**Box 5117**
**200 71 Malmö (SE)**

(54) **BITLINE MULTI-LEVEL VOLTAGE SENSING CIRCUIT**

(57)    The present invention relates to a bitline multi-level voltage sensing circuit for a multi-bit operation of a DRAM including a memory cell that stores data by an operation of a wordline and a bitline, the bitline multi-level voltage sensing circuit comprising: an operational amplifier having a non-inverting input terminal coupled to a precharging voltage line and an inverting input terminal coupled to a bitline through a first switch enabled by a wordline signal; a feedback capacitor formed between an output terminal of the operational amplifier and an inverting input terminal of the operational amplifier; a second switch formed in parallel with the feedback capacitor between the output terminal of the operational amplifier and the inverting input terminal of the operational amplifier and enabled by a precharging signal; and an analog-to-digital converter that converts an output voltage of the output terminal of the operational amplifier into a digital signal.

FIG. 2

**Description**

This present application claims the benefit of the earlier filing date of Korean non-provisional patent application No. 1 0-2021-0108384, filed on August 17, 2021, the entire contents of which being incorporated herein by reference.

The present disclosure relates to a circuit for sensing multi-level voltages of a bit line; and more particularly, to the circuit for sensing multi-level voltages of bit line to read data stored in a memory cell of DRAM which stores multi-bit data in one memory cell.

DRAM in a semiconductor memory device stores data in cells each of which includes a transistor and a capacitor. For example, the DRAM stores one bit data, e.g. "0" or "1", in each of the cells according to whether electric charge is stored in its corresponding capacitor.

Also, the DRAM determines whether to access a capacitor of a cell by using a word line capable of turning on or turning off the transistor, and the DRAM may store data in the capacitor or read the data stored in the capacitor by using a bit line.

Further, the DRAM includes a sense amplifier to read the data stored in the capacitor by using the bit line. Herein, the sense amplifier reads the data "1" or "0" by amplifying a change in a voltage of the bit line which varies due to a process of charge sharing between the capacitor and the bit line when the word line turns on the transistor.

In order to read the data in the DRAM by using the sense amplifier, a differential inverter may be formed between neighboring two bit lines, thereby allowing a voltage difference between the neighboring two bit lines to be detected.

Meanwhile, there are some suggestions about a multi-level DRAM which stores data larger than one bit in one cell unlike the general DRAM which stores only one bit, i.e. "0" or "1", in one cell comprised of the transistor and the capacitor.

However, according to the multi-level DRAM, a voltage difference between a reference voltage and its one or more neighboring reference voltages becomes smaller than a voltage difference of the general DRAM performing one bit operation and thus it is difficult to accurately detect a change in a voltage of the bit line by using the sense amplifier. Further, the multi-level DRAM cannot detect a slight change in a voltage of the bit line precisely because of a temperature or noise of the multi-level DRAM.

Accordingly, the present disclosure suggests a method for detecting multi-level voltages of the bit line in the multi-level DRAM.

It is an object of the present disclosure to solve all the aforementioned problems.

It is another object of the present disclosure to detect multi-level voltages of a bit line in a multi-level DRAM precisely.

It is still another object of the present disclosure to detect the multi-level voltages irrespective of temperature or noise.

It is still yet another object of the present disclosure to detect a cell voltage directly in the multi-level DRAM.

In accordance with one aspect of the present disclosure, there is provided a circuit for sensing multi-level voltages of a bit line, designed for multi-bit operations of DRAM including a memory cell that stores data through interaction of a word line and the bit line, comprising: the bit line connected to the memory cell operated by a word line signal from the word line; a 1-st switch whose one end is connected to the bit line and enabled by the word line signal; an operational amplifier including a noninverting input end connected to a pre-charging voltage line and an inverting input end connected to an opposite end of the 1-st switch; a feedback capacitor connected between an output end of the operational amplifier and the inverting input end thereof; a 2-nd switch connected to be in parallel with the feedback capacitor between the output end of the operational amplifier and the inverting input end thereof and enabled by a pre-charging signal from the pre-charging voltage line; and an analogue-to-digital converter configured to convert an output voltage of the operational amplifier to a digital signal.

As one example, the circuit further comprises: a power blocking unit enabled to block power supply of the operational amplifier in response to enabling the 2-nd switch; and a 3-rd switch enabled to feed the pre-charging signal to at least one of one end of the feedback capacitor and an opposite end of the feedback capacitor in response to enabling the 2-nd switch.

As one example, the power blocking unit is enabled in response to turning on the 2-nd switch and disabled before turning off the 2-nd switch by a predetermined delay time.

As one example, an offset capacitor is formed between the 1-st switch and the inverting input end of the operational amplifier and stores an offset voltage which is generated in response to an operation of the memory cell connected to the bit line.

As one example, the pre-charging voltage line, which is connected to the noninverting input end of the operational amplifier, is not the bit line connected to the 1-st switch but a different bit line connected to a dummy cell or fed with the pre-charging signal without charge sharing by a different memory cell connected to the different bit line.

As one example, on condition that (i-1) n-bit data has been converted to an analog signal by a digital-to-analog converter in response to an instructing signal for recording the n-bit data, wherein n is an integer larger than or equal to 2, (i-2) a specific input voltage corresponding to the n-bit data among a 1-st input voltage to a 2^n-th input voltage has been fed to the bit line by the digital-to-analog converter, wherein each of the 1-st input voltage to the 2^n-th input voltage designed for n-bit operations of the DRAM has a unit voltage gap of (the 2^n-th input voltage - the 1-st input voltage)/(2^n-1) with its neighboring one or more input voltages, (i-3) the word line has been enabled to charge the memory cell defined by the bit line and the word line by using electric charge corresponding to the specific input voltage, and then (i-4) the n-bit data have been recorded in the memory cell, in case the 1-st switch is disabled, (ii-1) the 2-nd switch is enabled in response to the pre-charging signal, thereby discharging electric charge of the feedback capacitor, (ii-2) the bit line is charged by the pre-charging signal which is defined as an average of the 1-st input voltage to the 2^n-th input voltage, and (ii-3) the pre-charging signal is fed to the noninverting input end of the operational amplifier; in case the 2-nd switch is disabled, in response to a word line signal fed for reading the n-bit data recorded in the memory cell, the memory cell is connected to the bit line and the 1-st switch is enabled, thereby inducing a charge redistribution which makes the output end of the operational amplifier provide an output voltage corresponding to a cell voltage of the memory cell; and the analog-to-digital converter converts the output voltage provided from the output end of the operational amplifier to the digital signal, thereby outputting the n-bit data.

As one example, the analog-to-digital converter inverts a binary bit value corresponding to the output voltage of the operational amplifier, thereby reading the n-bit data.

As one example, the analog-to-digital converter includes: a comparator configured to compare the output voltage of the operational amplifier fed to a 1-st input end of the comparator and a reference voltage fed to a 2-nd input end thereof; a reference voltage supplying part configured to feed the reference voltage to the 2-nd input end of the comparator according to a specific reference voltage switch selected among a 1-st reference voltage switch to a 2^(n-1)-th reference voltage switch, wherein the reference voltage supplying part feeds a specific reference voltage, corresponding to the specific reference voltage switch, among a 1-st reference voltage to a 2^(n-1)-th reference voltage through the specific reference voltage switch selected among the 1-st reference voltage switch to the 2^n-1-th reference voltage switch, and wherein the reference voltage supplying part includes the 1-st reference voltage switch to the 2^(n-1)-th reference switch which are connected in parallel with one another; and a switch selector configured to turn on the specific reference voltage switch among the 1-st reference voltage switch to the 2^(n-1)-th reference voltage switch, in response to the binary bit value outputted from the comparator.

As one example, analog-to-digital converter includes: a comparator configured to have a 1-st input end connected to a 1-st capacitor to an n-th capacitor for reading n-bit data and a dummy capacitor and a 2-nd input end connected to a ground line, wherein the 1-st capacitor to the n-th capacitor and the dummy capacitor are connected in parallel with one another; a sampling switch located in-between the 1-st input end of the comparator and the 2-nd input end thereof; a switching part which includes (i) a 1-st switch module to an n-th switch module each of which is connected to each of the 1-st capacitor to the n-th capacitor and each of which feeds one selected among the output voltage of the operational amplifier, a reference voltage and a ground voltage and (ii) a dummy switch module which is connected to the dummy capacitor and which feeds one selected among the output voltage of the operational amplifier and the ground voltage; and a switch selector configured to operate switches of the switching part in response to binary bit value outputted from the comparator.

As one example, the analog-to-digital converter includes each of multiple comparators configured to have each of 1-st input ends connected to the output end of the operational amplifier and each of the 2-nd input ends connected to each of corresponding reference voltage suppliers, wherein the reference voltage suppliers are preset for detecting multi-bit.

In accordance with another aspect of the present disclosure, there is provided DRAM comprising the circuit for sensing the multi-level voltages of the bit line.

The accompanying drawings used to explain example embodiments of the present disclosure are only part of example embodiments of the present disclosure and other drawings can be obtained based on the drawings by those skilled in the art of the present disclosure without inventive work.

Fig. 1 is a drawing schematically illustrating a DRAM including a circuit for sensing multi-level voltages of a bit line in accordance with one example embodiment of the present disclosure.

Fig. 2 is a drawing schematically illustrating the circuit for sensing the multi-level voltages of the bit line in accordance with one example embodiment of the present disclosure.

Fig. 3 is a drawing schematically illustrating the circuit for sensing the multi-level voltages of the bit line in accordance with another example embodiment of the present disclosure.

Fig. 4 is a drawing schematically illustrating one example of an analog-to-digital converter in the circuit for sensing the multi-level voltages of the bit line in accordance with one example embodiment of the present disclosure.

Fig. 5 is a drawing schematically illustrating another example of the analog-to-digital converter in the circuit for sensing the multi-level voltages of the bit line in accordance with one example embodiment of the present disclosure.

Fig. 6 is a drawing schematically illustrating still another example of the analog-to-digital converter in the circuit for sensing the multi-level voltages of the bit line in accordance with one example embodiment of the present disclosure.

The following detailed description of the present disclosure refers to the accompanying drawings, which show by way of illustration a specific embodiment in which the present disclosure may be practiced, in order to clarify the objects, technical solutions and advantages of the present disclosure. These embodiments are described in sufficient detail to enable those skilled in the art to practice the present disclosure.

Besides, in the detailed description and claims of the present disclosure, a term "include" and its variations are not intended to exclude other technical features, additions, components or steps. Other objects, benefits and features of the present disclosure will be revealed to one skilled in the art, partially from the specification and partially from the implementation of the present disclosure. The following examples and drawings will be provided as examples, but they are not intended to limit the present disclosure.

Moreover, the present disclosure covers all possible combinations of example embodiments indicated in this specification. It is to be understood that the various embodiments of the present disclosure, although different, are not necessarily mutually exclusive. For example, a particular feature, structure, or characteristic described herein in connection with one embodiment may be implemented within other embodiments without departing from the spirit and scope of the present disclosure. In addition, it is to be understood that the position or arrangement of individual elements within each disclosed embodiment may be modified without departing from the spirit and scope of the present disclosure. The following detailed description is, therefore, not to be taken in a limiting sense, and the scope of the present disclosure is defined only by the appended claims, appropriately interpreted, along with the full range of equivalents to which the claims are entitled. In the drawings, like numerals refer to the same or similar functionality throughout the several views.

To allow those skilled in the art to carry out the present disclosure easily, the example embodiments of the present disclosure will be explained by referring to attached diagrams in detail as shown below.

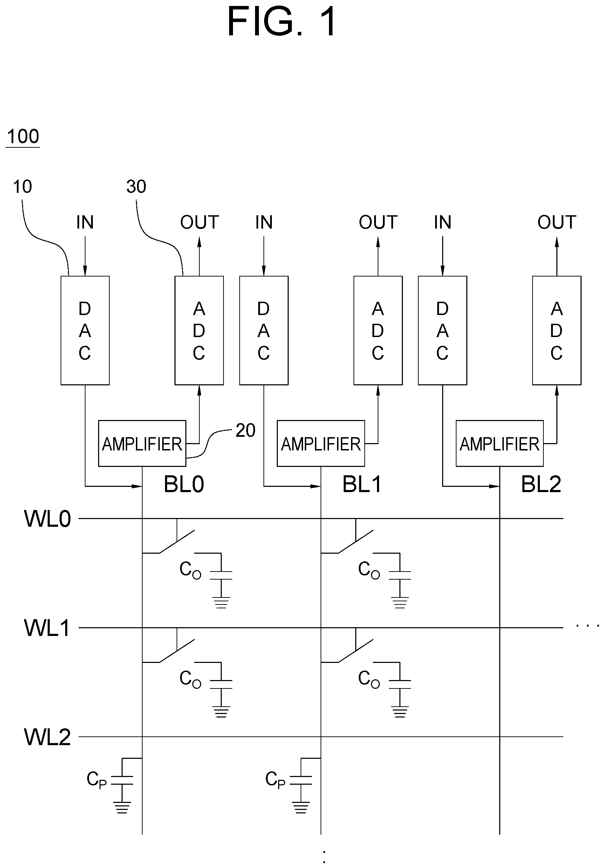

Fig. 1 is a drawing schematically illustrating a DRAM including a circuit for sensing multi-level voltages of a bit line in accordance with one example embodiment of the present disclosure.

By referring to Fig. 1, the DRAM 100 includes one or more bit lines, e.g., BL0, BL1, BL2, and the like, one or more word lines, e.g., WL0, WL1, WL2, and the like, and one or more memory cells $C_0$ defined by each of the bit lines and each of the word lines.

Herein, each of the memory cells includes a transistor and a capacitor. Also, the DRAM may determine whether to access a memory cell by using a word line, and may record n-bit data in the memory cell or read the n-bit data recorded in the memory cell by using a bit line. Herein n is an integer larger than or equal to 2.

Also, the bit line may be connected to a digital-to-analog converter 10 which feeds an input voltage corresponding to the n-bit data to the memory cell, an amplifier 20 which reads the n-bit data recorded in the memory cell, and an analog-to-digital converter 30.

Herein, the digital-to-analog converter 10 converts the n-bit data to be recorded in the memory cell into an analog signal. In detail, in response to inputting a specific n-bit data by using the word line to record the specific n-bit data in the memory cell, a specific input voltage corresponding to the specific n-bit data, among a 1-st input voltage to a $2^n$-th input voltage, is fed to the bit line so that the memory cell is charged with electric charge corresponding to the specific input voltage. Herein each of the 1-st input voltage to the $2^n$-th input voltage has been designed for inputting the n-bit data.

And the amplifier 20 may detect a cell voltage of the memory cell due to charge sharing between a pre-charged bit line and the memory cell.

Also, the analog-to-digital converter 30 may convert the cell voltage detected by the amplifier 20 to a digital signal, thereby reading the n-bit data.

Detailed explanation on the circuit for sensing the multi-level voltages of the bit line is provided below.

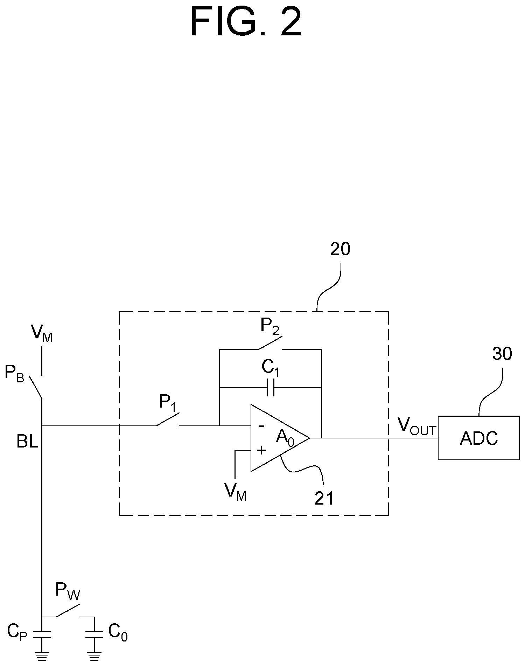

Fig. 2 is a drawing schematically illustrating the circuit for sensing the multi-level voltages of the bit line in accordance with one example embodiment of the present disclosure.

By referring to Fig. 2, the circuit for sensing the multi-level voltages of the bit line may include an operational amplifier 21, a feedback capacitor $C_1$, a 2-nd switch $P_2$ and an analog-to-digital converter 30.

First, the operational amplifier 21 may include a noninverting input end connected to a pre-charge voltage line and an inverting input end connected to a bit line BL through a 1-st switch $P_1$ enabled by a word line signal. The operational amplifier 21 may amplify a voltage difference between the noninverting input end and the inverting input end.

Herein, a pre-charging voltage $V_m$, i.e., a pre-charging signal, may be defined as an average of the 1-st input voltage to the $2^n$-th input voltage, each of which is used to record the n-bit data in the memory cell $C_0$.

Also, if a full-scale voltage $V_{FS}$ is defined as a full scale of the input voltages corresponding to the 1-st input voltage to the $2^n$-th input voltage, the pre-charging signal $V_m$ may be defined as an average of a minimum scale voltage and a maximum cale voltage. Herein the minimum scale voltage is acquired by subtracting a voltage of a least significant bit, i.e. LSB, from the 1-st input voltage and the maximum scale voltage is acquired by adding the voltage of the least significant bit to the $2^n$-th input voltage.

And a pre-charging voltage line for feeding the pre-charge signal $V_m$ is not the bit line BL corresponding to the memory cell $C_0$ but a different bit line connected to a dummy cell or fed with the pre-charging signal without charge sharing of a different memory cell connected to the different bit line.

Further, the feedback capacitor $C_1$ is formed between the output end of the operational amplifier 21 and the inverting input end thereof. Thus, the operational amplifier 21 can produce an inverted output voltage corresponding to the cell voltage of the memory cell $C_0$ by using the feedback capacitor $C_1$.

And the 2-nd switch $P_2$ is formed to be in parallel with the feedback capacitor $C_1$ between the output end of the operational amplifier 21 and the inverting input end thereof, and the 2-nd switch $P_2$ is enabled by the pre-charging signal, thereby discharging the electric charge stored in the feedback capacitor $C_1$.

Finally, the analog-to-digital convertor 30 may convert the output voltage of the output end of the operational amplifier 21 to the digital signal, thereby reading the n-bit data recorded in the memory cell.

Detailed explanation on reading the n-bit data recorded in the memory cell by using the circuit for sensing the multi-level voltages of the bit line in accordance with one example embodiment of the present disclosure is provided below.

First, on condition that a switch $P_w$, i.e., the transistor of the memory cell, is turned on by the word line WL such that the memory cell $C_0$ can be accessed, the specific input voltage for recording the specific n-bit data, among the 1-st input voltage to the $2^n$-th input voltage for recording the n-bit data, is fed to the bit line BL and, as a result, the memory cell $C_0$ is charged with the electric charge corresponding to the specific input voltage, thereby recording the specific n-bit data in the memory cell $C_0$.

Then, on condition that the 1-st switch $P_1$ is turned off and disabled, in response to the pre-charging signal, a bit line switch $P_B$ is turned on such that the bit line BL is charged by the pre-charging signal $V_m$.

At the same time, the 2-nd switch $P_2$ is turned on and the electric charge remained on the feedback capacitor $C_1$ is removed, thereby initializing the feedback capacitor $C_1$.

Then, the electric charge in the circuit can be described as below:

$$Q_1 = C_p V_m + C_0 V_{cell} + C_1(V_m - V_m)$$

Herein, $V_{cell}$ is the cell voltage of the memory cell and $C_p$ is a parasitic capacitance corresponding to the bit line BL.

Next, (i) both the bit line switch $P_B$ and the 2-nd switch $P_2$ are turned off, (ii) in response to the word line signal for reading the n-bit data recorded in the memory cell, the switch $P_w$, i.e., the transistor of the memory cell $C_0$, is turned on and thus the memory cell $C_0$ is allowed to be connected to the bit line BL, and (iii) the 1-st switch $P_1$ is turned on and thus a bit line voltage is allowed to be fed to the inverting input end of the operational amplifier 21.

As a result, the operational amplifier 21 may amplify the voltage difference between a voltage inputted to the inverting input end and the pre-charging signal $V_m$ inputted to the noninverting input end, thereby providing the output voltage $V_{out}$.

And the feedback capacitor $C_1$ may feedback the output voltage $V_{out}$ of the operational amplifier 21 to the inverting input end of the operational amplifier 21.

Accordingly, charge redistribution occurs for the circuit, and electric charge after the charge redistribution can be described as below:

$$Q_2 = C_p V_m + C_0 V_m + C_1(V_m - V_{out})$$

Since the electric charge before and after the charge redistribution is conserved, $Q_1$ is equal to $Q_2$ and, as a result, the output voltage $V_{out}$ of the operational amplifier 21 can be described as below:

$$C_p V_m + C_0 V_{cell} + C_1(V_m - V_m) = C_p V_m + C_0 V_m + C_1(V_m - V_{out})$$

$$C_0(V_{cell} - V_m) = C_1(V_m - V_{out})$$

$$V_{out} = V_m - \frac{C_0}{C_1}(V_{cell} - V_m)$$

As a result, the amplifier 20 of the present disclosure can precisely detect the cell voltage of the memory cell unlike the conventional sense amplifier which amplifies a change in a voltage of the bit line but cannot detect the cell voltage precisely.

Herein, in case the capacitance of the feedback capacitor $C_1$ is set to be equal to the capacitance of the memory cell, the output voltage $V_{out}$ of the operational amplifier 21 can be described as $V_{out} = 2V_m - V_{cell}$ which represents that the output voltage is calculated by subtracting the cell voltage from a greatest input voltage for the n-bit data. That is, the output voltage inverted to the cell voltage can be obtained.

Next, the analog-to-digital convertor 30 may convert the output voltage $V_{out}$ provided at the output end of the operational amplifier 21 into a binary bit value, i.e., the digital signal, thereby outputting the n-bit data.

Herein, the analog-to-digital converter 30 may output the n-bit data by inverting the binary bit value corresponding to the output voltage $V_{out}$ provided at the output end of the operational amplifier 21. Since the output voltage $V_{out}$ provided at the operational amplifier 21 is an inverted cell voltage, the n-bit data corresponding to the cell voltage can be read by inverting the binary bit value.

Meanwhile, an offset voltage can be generated in the DRAM because of abnormalities of the memory cells connected to the bit line.

In case the offset voltage is generated, the operational amplifier 21 may compare the bit line voltage with a distorted voltage which is a result of adding the offset voltage to a reference voltage.

Therefore, to alleviate the problem caused by the offset voltage, an offset capacitor may be provided to the inverting input end of the operational amplifier 21. In detail, the offset capacitor may store electric charge of the offset voltage caused by the abnormalities of the memory cells and thus may regulate the offset voltage by using the electric charge stored therein during operations of the operational amplifier 21.

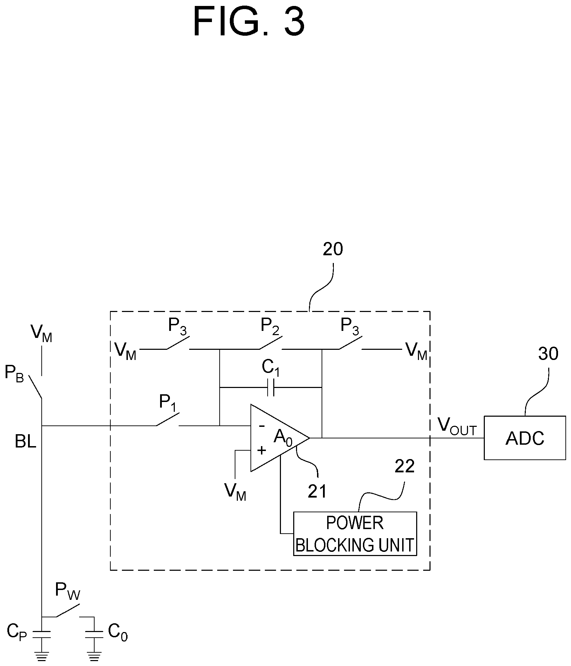

Fig. 3 is a drawing schematically illustrating the circuit for sensing the multi-level voltages of the bit line in accordance with another example embodiment of the present disclosure. Fig. 3 represents a power-down mode of the circuit for sensing the multi-level voltages of the bit line shown in Fig. 2. Herein, the power-down mode is a mode for reducing power consumption in the DRAM.

By referring to Fig. 3, the circuit for sensing multi-level voltages of the bit line of Fig. 2 further includes a power blocking unit 22 configured to block power supply of the operational amplifier 21 in response to enabling the 2-nd switch $P_2$.

In detail, while the feedback capacitor $C_1$ is initialized by an operation of the 2-nd switch $P_2$, the power blocking unit 22 blocks the power supply for the operational amplifier 21, thereby reducing the power consumption caused by the operations of the operational amplifier 21.

The power blocking unit 22 is enabled in response to turning on the 2-nd switch $P_2$ and is disabled before turning off the 2-nd switch $P_2$ by a predetermined delay time.

That is, since a certain time is needed for the operations of the operational amplifier 21 after the power supply is fed to the operational amplifier 21, the power supply may be fed to the operational amplifier 21 before turning off the 2-nd switch $P_2$ by the predetermined delay time, in consideration of the certain time.

Meanwhile, on condition that the power supply for the operational amplifier 21 is blocked, i.e., on condition that the operational amplifier 21 does not operate, a negative input cannot be defined since there is no feedback even if the 2-nd switch $P_2$ is turned on.

Therefore, to define a negative voltage, a 3-rd switch $P_3$ may be provided to feed the pre-charging signal $V_m$ to at least one end of the feedback capacitor $C_1$. Herein the 3-rd switch $P_3$ is enabled in response to enabling the 2-nd switch $P_2$.

Only one 3-rd switch $P_3$ may be connected to one end of the feedback capacitor $C_1$ to feed the pre-charging signal $V_m$ or alternatively two 3-rd switches $P_3$ switches may be connected to both ends of the feedback capacitor $C_1$ to feed the pre-charging signal $V_m$ to both ends of the feedback capacitor $C_1$ to reduce time for setting.

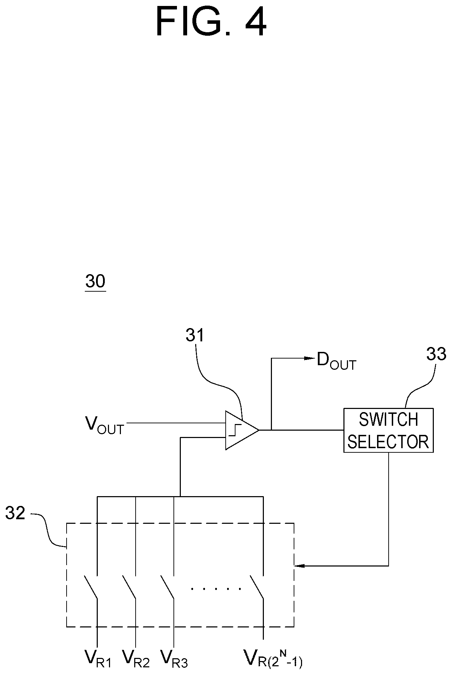

By referring to Fig. 4 to Fig. 6, the analog-to-digital converter for converting the output voltage of the operational amplifier into the digital signal in accordance with one example embodiment of the present invention is described below.

Fig. 4 is a drawing schematically illustrating one example of the analog-to-digital converter in the circuit for sensing the multi-level voltages of the bit line in accordance with one example embodiment of the present disclosure.

By referring to Fig. 4, the analog-to-digital converter 30 may include a comparator 31, a reference voltage supplying part 32, and a switch selector 33.

The comparator 31 may compare the output voltage of the operational amplifier 21 fed to a 1-st input end of the comparator 31 and a reference voltage fed to a 2-nd input end thereof, thereby outputting the binary bit value as a result.

The reference voltage supplying part 32 may be configured to feed a specific reference voltage to the 2-nd input end of the comparator 31 according to operations of a specific reference voltage switch selected among a 1-st reference voltage switch to a $2^{(n-1)}$-th reference voltage switch. That is, the reference voltage supplying part 32 feeds the specific reference voltage, corresponding to the specific reference voltage switch, among a 1-st reference voltage to a $2^{(n-1)}$-th reference voltage designed for reading the n-bit data, through the specific reference voltage switch selected among the 1-st reference voltage switch to the $2^{(n-1)}$-th reference voltage switch. Herein the reference voltage supplying part 32 includes the 1-st reference voltage switch to the $2^{(n-1)}$-th reference switch which are connected in parallel with one another.

The switch selector 33 may be configured to turn on the specific reference voltage switch among the 1-st reference voltage switch to the $2^{(n-1)}$-th reference voltage switch of the reference voltage supplying part 32, in response to the binary bit value outputted from the comparator 31.

A process of converting the output voltage of the operational amplifier to the digital data using the analog-to-digital converter 30 is explained below.

First, in the analog-to-digital converter 30, the output voltage of the operational amplifier 21 is fed to the 1-st input end of the comparator 31 and a median reference voltage for checking a most significant bit, i.e., MSB, is fed to the 2-nd input end of the comparator 31 through the reference voltage supplying part 32 and then the comparator 31 compares the output voltage of the operational amplifier 21 and the median reference voltage to thereby output "0" or "1".

Then, the switch selector 33 feeds a reference voltage with a next priority, selected among a reference voltage with a positive next priority and a reference voltage with a negative next priority, to the 2-nd input end of the comparator 31 and then the comparator 31 compares the output voltage of the operational amplifier 21 and the reference voltage with the next priority to thereby output a bit value with a next priority. Herein, the reference voltage with the next priority is used to check a next most significant bit according to a value of the MSB. The processes above are repeated n times, thereby outputting the n-bit data corresponding to the output voltage of the operational amplifier 21.

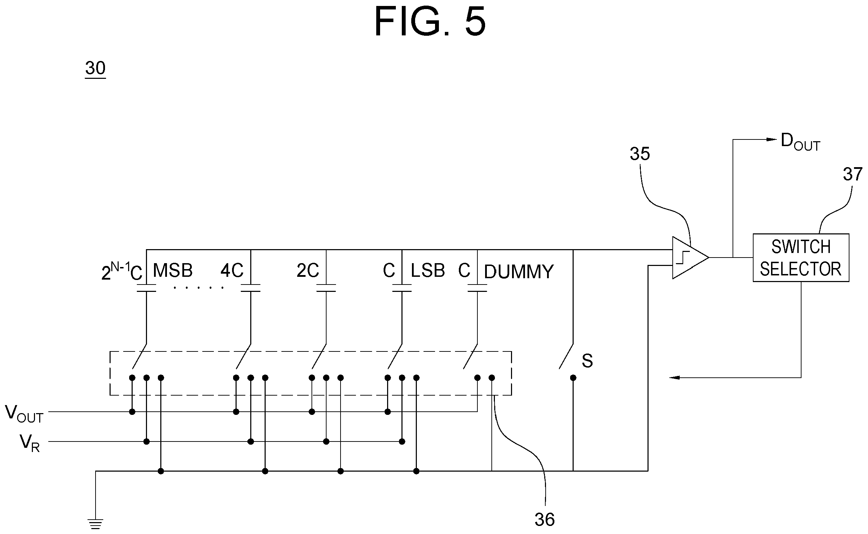

Fig. 5 is a drawing schematically illustrating another example of the analog-to-digital converter in the circuit for sensing the multi-level voltages of the bit line in accordance with one example embodiment of the present disclosure.

By referring to Fig. 5, the analog-to-digital converter 30 may include a comparator 35, a sampling switch S, a switching part 36, and a switch selector 37.

The comparator 35 is configured to have a 1-st input end connected to a 1-st capacitor $2^{(n-1)}$C to an n-th capacitor C for reading the n-bit data and a dummy capacitor C and a 2-nd input end connected to a ground line. Herein the 1-st capacitor $2^{(n-1)}$C to the n-th capacitor C and the dummy capacitor C are connected in parallel with one another.

The sampling switch S is located in-between the 1-st input end of the comparator 35 and the 2-nd input end thereof.

The switching part 36 includes a 1-st switch module to an n-th switch module each of which is connected to each of the 1-st capacitor to the n-th capacitor and each of which feeds one selected among the output voltage of the operational amplifier, a reference voltage and a ground voltage. The switching part 36 also includes a dummy switch module which is connected to a dummy capacitor and which feeds one selected among the output voltage of the operational amplifier and the ground voltage.

The switch selector 37 is configured to operate switches of the switching part 36 in response to binary bit value outputted from the comparator 35.

The process of converting the output voltage of the operational amplifier to the digital data is explained below.

First, the sampling switch S is turned on and then the output voltage $V_{out}$ of the operational amplifier is fed to the 1-st capacitor to the n-th capacitor and the dummy capacitor by operations of the 1-st switch module to the n-th switch module and the dummy switch module, thereby sampling a voltage of the 1-st input end of the comparator 35 to be corresponding to the output voltage of the operational amplifier.

Herein, a sampling voltage may be $-V_{out}$ and the n-bit data is set as 1000....

Next, the sampling switch S is turned off and then the switch selector 37 feeds the reference voltage $V_R$ to the 1-st capacitor $2^{(n-1)}$C through the 1-st switch module and feeds a ground voltage to each of other capacitors through each of its corresponding switch modules.

Then, the voltage of the 1-st input end of the comparator 35 is $(-V_{out}) + V_R/2$.

Then, if $V_{out}$ is larger than $V_R/2$, the comparator 35 outputs "1" and if $V_{out}$ is smaller than $V_R/2$, the comparator 35 outputs "0".

Then, in case the output of the comparator 35 for checking the most significant bit is "1", the most significant bit is maintained as "1", and then the switch selector 37 allows the reference voltage $V_R$ to be fed to the 2-nd capacitor $2^{(n-2)}$C through the 2-nd switch module in order to check a value of a next most significant bit.

Meanwhile, in case the output of the comparator 35 for checking the most significant bit is "0", the most significant bit value is changed from "1" to "0", and accordingly, the switch selector 37 allows the ground voltage to be fed to the 1-st capacitor $2^{(n-1)}$C through the 1-st switch module and allows the reference voltage $V_R$ to be fed to the 2-nd capacitor $2^{(n-2)}$C through the 2-nd switch module in order to check a value of the next most significant bit.

The processes above are repeated until the n-th capacitor C is fed with the reference voltage and, as a result, the output voltage of the operational amplifier is converted to the n-bit data.

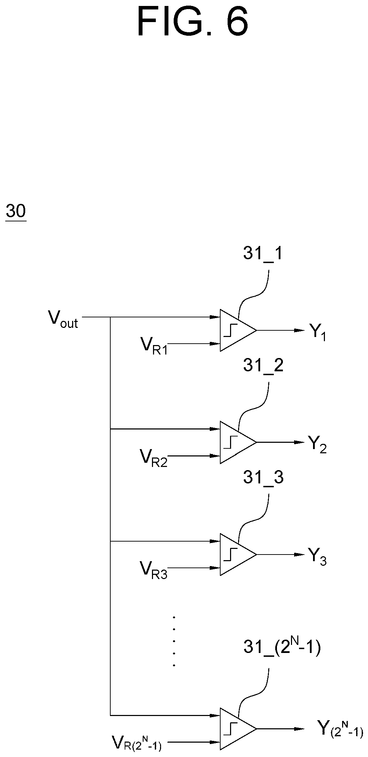

Fig. 6 is a drawing schematically illustrating still another example of the analog-to-digital converter in the circuit for sensing the multi-level voltages of the bit line in accordance with one example embodiment of the present disclosure.

By referring to Fig. 6, the analog-to-digital converter 30 includes multiple comparators 31_1 to 31_$(2^n -1)$. In detail, each of 1-st input ends of the analog-to-digital converter 30 is connected to the output end of the operational amplifier and each of 2-nd input ends of the analog-to-digital converter 30 is connected to each of corresponding reference voltage suppliers preset for detecting multi-bit.

The analog-to-digital converter 30 may output "0" or "1" by allowing each of the comparators to compare the output voltage of the operational amplifier with its corresponding reference voltage. Then, the analog-to-digital converter 30 may convert the output voltage of the operational amplifier to the n-bit data by using each of outputs from each of the comparators in one cycle.

Also, the example embodiment of the present disclosure can be implemented in the DRAM, thereby supporting the DRAM to perform the multi-bit operations.

The present invention has an effect of detecting the multi-level voltages of the bit line in the multi-level DRAM precisely.

The present invention has another effect of detecting the multi-level voltages irrespective of temperature or noise.

The present invention has still another effect of detecting the cell voltage directly in the multi-level DRAM.

As seen above, the present disclosure has been explained by specific matters such as detailed components, limited embodiments, and drawings. While the invention has been shown and described with respect to the preferred embodiments, it, however, will be understood by those skilled in the art that various changes and modification may be made without departing from the spirit and scope of the invention as defined in the following claims.

Accordingly, the thought of the present disclosure must not be confined to the explained embodiments, and the following patent claims as well as everything including variations equal or equivalent to the patent claims pertain to the category of the thought of the present disclosure.

**Claims**

1.    A circuit for sensing multi-level voltages of a bit line, designed for multi-bit operations of DRAM including a memory cell that stores data through interaction of a word line and the bit line, comprising:

the bit line connected to the memory cell operated by a word line signal from the word line;
a 1-st switch whose one end is connected to the bit line and enabled by the word line signal;
an operational amplifier including a noninverting input end connected to a pre-charging voltage line and an inverting input end connected to an opposite end of the 1-st switch;
a feedback capacitor connected between an output end of the operational amplifier and the inverting input end thereof;
a 2-nd switch connected to be in parallel with the feedback capacitor between the output end of the operational amplifier and the inverting input end thereof and enabled by a pre-charging signal from the pre-charging voltage line; and
an analogue-to-digital converter configured to convert an output voltage of the operational amplifier to a digital signal.

2.    The circuit of Claim 1, further comprising:

a power blocking unit enabled to block power supply of the operational amplifier in response to enabling the 2-nd switch; and
a 3-rd switch enabled to feed the pre-charging signal to at least one of one end of the feedback capacitor and an opposite end of the feedback capacitor in response to enabling the 2-nd switch.

3.    The circuit of Claim 2, wherein the power blocking unit is enabled in response to turning on the 2-nd switch and disabled before turning off the 2-nd switch by a predetermined delay time.

4.    The circuit of Claim 1, wherein an offset capacitor is formed between the 1-st switch and the inverting input end of the operational amplifier and stores an offset voltage which is generated in response to an operation of the memory cell connected to the bit line.

5.    The circuit of Claim 1, wherein the pre-charging voltage line, which is connected to the noninverting input end of the operational amplifier, is not the bit line connected to the 1-st switch but a different bit line connected to a dummy cell or fed with the pre-charging signal without charge sharing by a different memory cell connected to the different bit line.

6.    The circuit of Claim 1, wherein, on condition that (i-1) n-bit data has been converted to an analog signal by a digital-to-analog converter in response to an instructing signal for recording the n-bit data, wherein n is an integer larger than or equal to 2, (i-2) a specific input voltage corresponding to the n-bit data among a 1-st input voltage to a $2^n$-

th input voltage has been fed to the bit line by the digital-to-analog converter, wherein each of the 1-st input voltage to the 2^n-th input voltage designed for n-bit operations of the DRAM has a unit voltage gap of (the 2^n-th input voltage - the 1-st input voltage)/(2^n-1) with its neighboring one or more input voltages, (i-3) the word line has been enabled to charge the memory cell defined by the bit line and the word line by using electric charge corresponding to the specific input voltage, and then (i-4) the n-bit data have been recorded in the memory cell,

in case the 1-st switch is disabled, (ii-1) the 2-nd switch is enabled in response to the pre-charging signal, thereby discharging electric charge of the feedback capacitor, (ii-2) the bit line is charged by the pre-charging signal which is defined as an average of the 1-st input voltage to the 2^n-th input voltage, and (ii-3) the pre-charging signal is fed to the noninverting input end of the operational amplifier;
in case the 2-nd switch is disabled, in response to a word line signal fed for reading the n-bit data recorded in the memory cell, the memory cell is connected to the bit line and the 1-st switch is enabled, thereby inducing a charge redistribution which makes the output end of the operational amplifier provide an output voltage corresponding to a cell voltage of the memory cell; and
the analog-to-digital converter converts the output voltage provided from the output end of the operational amplifier to the digital signal, thereby outputting the n-bit data.

7. The circuit of Claim 1, wherein the analog-to-digital converter inverts a binary bit value corresponding to the output voltage of the operational amplifier, thereby reading n-bit data.

8. The circuit of Claim 1, wherein the analog-to-digital converter includes:

a comparator configured to compare the output voltage of the operational amplifier fed to a 1-st input end of the comparator and a reference voltage fed to a 2-nd input end thereof;
a reference voltage supplying part configured to feed the reference voltage to the 2-nd input end of the comparator according to a specific reference voltage switch selected among a 1-st reference voltage switch to a 2^(n-1)-th reference voltage switch, wherein the reference voltage supplying part feeds a specific reference voltage, corresponding to the specific reference voltage switch, among a 1-st reference voltage to a 2^(n-1)-th reference voltage through the specific reference voltage switch selected among the 1-st reference voltage switch to the 2^n-1-th reference voltage switch, and wherein the reference voltage supplying part includes the 1-st reference voltage switch to the 2^(n-1)-th reference switch which are connected in parallel with one another; and
a switch selector configured to turn on the specific reference voltage switch among the 1-st reference voltage switch to the 2^(n-1)-th reference voltage switch, in response to the binary bit value outputted from the comparator.

9. The circuit of Claim 1, wherein the analog-to-digital converter includes:

a comparator configured to have a 1-st input end connected to a 1-st capacitor to an n-th capacitor for reading n-bit data and a dummy capacitor and a 2-nd input end connected to a ground line, wherein the 1-st capacitor to the n-th capacitor and the dummy capacitor are connected in parallel with one another;
a sampling switch located in-between the 1-st input end of the comparator and the 2-nd input end thereof;
a switching part which includes (i) a 1-st switch module to an n-th switch module each of which is connected to each of the 1-st capacitor to the n-th capacitor and each of which feeds one selected among the output voltage of the operational amplifier, a reference voltage and a ground voltage and (ii) a dummy switch module which is connected to the dummy capacitor and which feeds one selected among the output voltage of the operational amplifier and the ground voltage; and
a switch selector configured to operate switches of the switching part in response to binary bit value outputted from the comparator.

10. The circuit of claim 1, wherein the analog-to-digital converter includes each of multiple comparators configured to have each of 1-st input ends connected to the output end of the operational amplifier and each of 2-nd input ends connected to each of corresponding reference voltage suppliers, wherein the reference voltage suppliers are preset for detecting multi-bit.

11. The DRAM comprising the circuit for sensing the multi-level voltages of the bit line according to any one of claim 1 to claim 10.

# FIG. 1

# FIG. 2

# FIG. 3

# FIG. 4

30

31

$V_{OUT}$ → (amplifier) → $D_{OUT}$

33 SWITCH SELECTOR

32

$V_{R1}$ $V_{R2}$ $V_{R3}$ . . . . . $V_{R(2^N-1)}$

FIG. 5

# FIG. 6

30

## INTERNATIONAL SEARCH REPORT

| International application No. |
| --- |
| **PCT/KR2021/016738** |

**A.  CLASSIFICATION OF SUBJECT MATTER**

**G11C 11/4091**(2006.01)i; **G11C 11/408**(2006.01)i; **G11C 11/4094**(2006.01)i; **H03M 1/12**(2006.01)i

According to International Patent Classification (IPC) or to both national classification and IPC

**B.  FIELDS SEARCHED**

Minimum documentation searched (classification system followed by classification symbols)

G11C 11/4091(2006.01); G06F 1/3234(2019.01); G06F 3/041(2006.01); G11C 13/02(2006.01); G11C 16/04(2006.01); G11C 7/06(2006.01); H04N 5/335(2011.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 오피 앰프(op-amp: operational amplifier), 피드백 커패시터(feedback capacitor), 아날로그-디지털 컨버터(ADC: Analog-to-Digital Converter), 스위치(switch)

**C.  DOCUMENTS CONSIDERED TO BE RELEVANT**

| Category* | Citation of document, with indication, where appropriate, of the relevant passages | Relevant to claim No. |
| --- | --- | --- |
| X | US 2020-0233482 A1 (SILICON STORAGE TECHNOLOGY, INC.) 23 July 2020 (2020-07-23) See paragraphs [0088] and [0157]-[0172]; and figures 22-34A. | 1,4,11 |
| Y |  | 7,10 |
| A |  | 2-3,5-6,8-9 |
| Y | JIANG, Zhewei et al. C3SRAM: An In-Memory-Computing SRAM Macro Based on Robust Capacitive Coupling Computing Mechanism. IEEE Journal of Solid-State Circuits. Vol. 55, No. 7, pp. 1888-1897, July 2020. Retrieved from <URL: https://ieeexplore.ieee.org/document/9094713>. See page 1891; and figure 1. | 7,10 |
| A | KR 10-2010-0049926 A (SAMSUNG ELECTRONICS CO., LTD.) 13 May 2010 (2010-05-13) See paragraphs [0027]-[0044]; and figure 2. | 1-11 |
| A | KR 10-2011-0026812 A (SILICON WORKS CO., LTD. et al.) 16 March 2011 (2011-03-16) See paragraphs [0029]-[0051]; and figures 5a-5c. | 1-11 |

☑ Further documents are listed in the continuation of Box C.    ☑ See patent family annex.

| \* | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **19 April 2022** | **19 April 2022** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**

| International application No. |
| --- |
| **PCT/KR2021/016738** |

**C.      DOCUMENTS CONSIDERED TO BE RELEVANT**

| Category* | Citation of document, with indication, where appropriate, of the relevant passages | Relevant to claim No. |
| --- | --- | --- |
| A | KR 10-2009-0072870 A (SAMSUNG ELECTRONICS CO., LTD.) 02 July 2009 (2009-07-02)<br>See paragraphs [0031]-[0041]; and figure 5. | 1-11 |

Form PCT/ISA/210 (second sheet) (July 2019)

**INTERNATIONAL SEARCH REPORT**
**Information on patent family members**

International application No.

**PCT/KR2021/016738**

| Patent document cited in search report | | | Publication date (day/month/year) | Patent family member(s) | | | Publication date (day/month/year) |
|---|---|---|---|---|---|---|---|
| US | 2020-0233482 | A1 | 23 July 2020 | CN | 111386572 | A | 07 July 2020 |
| | | | | CN | 113366506 | A | 07 September 2021 |
| | | | | EP | 3676840 | A1 | 08 July 2020 |
| | | | | EP | 3766178 | A1 | 20 January 2021 |
| | | | | JP | 2021-504868 | A | 15 February 2021 |
| | | | | KR | 10-2021-0105428 | A | 26 August 2021 |
| | | | | KR | 10-2021-0107101 | A | 31 August 2021 |
| | | | | KR | 10-2021-0110354 | A | 07 September 2021 |
| | | | | KR | 10-2350213 | B1 | 11 January 2022 |
| | | | | TW | 201933361 | A | 16 August 2019 |
| | | | | TW | 202032561 | A | 01 September 2020 |
| | | | | TW | 202032562 | A | 01 September 2020 |
| | | | | TW | 202046183 | A | 16 December 2020 |
| | | | | US | 10699779 | B2 | 30 June 2020 |
| | | | | US | 10720217 | B1 | 21 July 2020 |
| | | | | US | 10748630 | B2 | 18 August 2020 |
| | | | | US | 10803943 | B2 | 13 October 2020 |
| | | | | US | 2019-0164617 | A1 | 30 May 2019 |
| | | | | US | 2019-0237136 | A1 | 01 August 2019 |
| | | | | US | 2019-0286976 | A1 | 19 September 2019 |
| | | | | US | 2020-0243139 | A1 | 30 July 2020 |
| | | | | WO | 2019-177698 | A1 | 19 September 2019 |
| | | | | WO | 2020-159581 | A1 | 06 August 2020 |
| KR | 10-2010-0049926 | A | 13 May 2010 | US | 2010-0110768 | A1 | 06 May 2010 |
| | | | | US | 8228709 | B2 | 24 July 2012 |
| KR | 10-2011-0026812 | A | 16 March 2011 | TW | 201112088 | A | 01 April 2011 |
| | | | | US | 2012-0169701 | A1 | 05 July 2012 |
| | | | | WO | 2011-031032 | A2 | 17 March 2011 |
| | | | | WO | 2011-031032 | A3 | 30 June 2011 |
| KR | 10-2009-0072870 | A | 02 July 2009 | US | 2009-0167585 | A1 | 02 July 2009 |
| | | | | US | 7755531 | B2 | 13 July 2010 |

Form PCT/ISA/210 (patent family annex) (July 2019)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210108384